# EUROPÄISCHE PATENTSCHRIFT

(11) **EP 2 784 880 B1**
(45) Veröffentlichungstag und Bekanntmachung des Hinweises auf die Patenterteilung: **26.09.2018**
(21) Anmeldenummer: 14161506.2
(22) Anmeldetag: 25.03.2014
(51) Int. Cl.: H01R 13/52, H02G 15/013, H05K 5/06

(54) **Kabeldurchführung**
Cable feedthrough
Passe-câble

(30) Priorität: 28.03.2013 DE 102013205666
(43) Veröffentlichungstag der Anmeldung: 01.10.2014
(73) Patentinhaber: Lapp Engineering & Co., 6330 Cham (CH)
(72) Erfinder: Drotleff, Rolf, 75932 Deckenpfronn (DE); Müller, Daniel, 71686 Remseck (DE)
(74) Vertreter: Hoeger, Stellrecht & Partner Patentanwälte mbB

(56) Entgegenhaltungen:
- EP-A2- 1 898 506
- DE-U1-202010 006 132
- JP-A- 2009 048 929

## Beschreibung

Die Erfindung betrifft eine Kabeldurchführung für ein Schalt- oder Gerätegehäuse, umfassend einen an einem Wandabschnitt, insbesondere des Schalt- oder Gerätegehäuses, fixierbaren und sich in Richtung einer Mittelachse erstreckenden Gehäusestutzen mit einer in diesem vorgesehenen Dichtungsaufnahme, ein in der Dichtungsaufnahme angeordnetes Dichtelement mit einem deformierbaren Dichtungskörper und mit einem den Dichtungskörper in Richtung der Mittelachse durchsetzenden Durchführungskanal, der in einem ersten Deformationszustand des Dichtungskörpers einen größeren Durchführungsquerschnitt aufweist als in einem zweiten Deformationszustand, und ferner umfassend ein einen Druckkörper aufweisendes Druckelement zur Überführung des Dichtungskörpers von dem ersten Deformationszustand in den zweiten Deformationszustand, welches an dem Gehäusestutzen axial verschiebbar geführt ist, welches das Druckelement in seiner den Dichtungskörper im zweiten Deformationszustand haltenden Druckstellung an dem Gehäusestutzen durch mindestens ein Rastelement festgelegt ist, und welches mit mindestens einem Rastelement versehen ist, welches seinerseits in eine verrastende Stellung bringbar ist und in der verrastenden Stellung in eine Ausnehmung in dem Gehäusestutzen eingreift.

Derartige Kabeldurchführungen sind aus der JP 2009 048929 A bekannt, bei diesen wird der Dichtungskörper deformiert um eine Abdichtung des hindurchgeführten Kabels zu erreichen.

Zur Deformation des Dichtungskörpers sind dabei die verschiedensten Möglichkeiten vorgesehen, die alle eine mechanisch relativ aufwändige Realisierung erfordern.

Der Erfindung liegt daher die Aufgabe zugrunde, eine Kabeldurchführung der eingangs beschriebenen Art derart zu verbessern, dass diese einfach und mit geringem Aufwand realisierbar ist und außerdem eine einfache Möglichkeit zur Abdichtung relativ zu dem durch die Kabeldurchführung hindurchgeführten Kabel ermöglicht.

Diese Aufgabe wird bei einer Kabeldurchführung der eingangs beschriebenen Art erfindungsgemäß durch die Merkmale des Anspruchs 1 gelöst.

Der Vorteil der erfindungsgemäßen Lösung ist somit darin zu sehen, dass dieses eine einfache Möglichkeit eröffnet, das Druckelement von dem ersten Deformationszustand in den zweiten Deformationszustand zu überführen und in diesem zweiten Deformationszustand die erforderliche Abdichtung zum durch das Dichtelement hindurchgeführten Kabel zu realisieren.

Dabei ist der erste Deformationszustand so gewählt, dass sich in diesem ein Kabel durch den Durchführungskanal des Dichtungsköpers frei hindurchführen lässt, da der Durchführungsquerschnitt, der im ersten Deformationszustand größer ist als im zweiten Deformationszustand, dies erlaubt, während im zweiten Deformationszustand durch die Reduzierung des Durchführungsquerschnitts ein dicht abschließendes Anliegen des Dichtungskörpers an einer Mantelfläche des Kabels erfolgt.

Insbesondere ist es bei der erfindungsgemäßen Lösung möglich, auf sehr einfache Weise einen dichten Abschluss zwischen dem Dichtelement und dem Kabel zu realisieren, da primär lediglich eine axiale Bewegung des Druckelements erforderlich ist.

Eine besonders vorteilhafte Lösung sieht vor, dass das Druckelement in seiner Druckstellung mit einem auf das Dichtelement einwirkenden Druckkörper in dem Gehäusestutzen sitzt.

Damit greift das Druckelement in seiner Druckstellung mindestens mit dem Druckkörper in den Gehäusestutzen ein.

Besonders günstig ist es, wenn das Druckelement in seiner Druckstellung mit dem Druckkörper in einer Druckkörperaufnahme des Gehäusestutzens angeordnet ist.

Eine vorteilhafte Lösung sieht vor, dass das Druckelement durch die Druckelementaufnahme axial bewegbar geführt ist.

Damit ist es beispielsweise möglich, eine ausschließlich axiale Bewegung zum Erreichen der Druckstellung vorzusehen.

Besonders vorteilhaft ist es, wenn das Druckelement mit mehreren Rastelementen versehen ist.

Mehrere Rastelemente erlauben es beispielsweise, eine mehrseitige Fixierung des Druckelements in der Druckstellung zu realisieren.

Eine andere vorteilhafte Lösung sieht vor, dass das Druckelement an dem Gehäusestutzen in einer Montagestellung positionierbar ist, in welcher dieses den Dichtungskörper in dem ersten Deformationszustand belässt, das heißt, dass durch das Druckelement in der Montagestellung nicht über den ersten Deformationszustand hinausgehend auf den Dichtungskörper einwirkt.

Besonders vorteilhaft ist es dabei, wenn das Druckelement in der Montagestellung durch mindestens ein Rastelement an dem Gehäusestutzen fixierbar ist.

Eine besonders einfache Lösung sieht jedoch vor, dass das Rastelement, welches das Druckelement in der Montagestellung am Gehäusestutzen fixiert, dasselbe Rastelement ist, welches dann auch das Druckelement in der Druckstellung am Gehäusestutzen fixiert.

Hinsichtlich der Beaufschlagung des Dichtungskörpers im ersten Deformationszustand wurde lediglich festgelegt, dass diese derart sein soll, dass der Durchführungsquerschnitt größer ist als im zweiten Deformationszustand.

Eine besonders günstige Lösung sieht jedoch vor, dass der Dichtungskörper in dem ersten Deformationszustand axial unbeaufschlagt ist.

Insbesondere ist dabei vorgesehen, dass der Dichtungskörper in dem ersten Deformationszustand eine Form aufweist, die seiner Herstellungsform entspricht, das heißt, dass der Dichtungskörper in dem ersten Deformationszustand keinerlei deformierenden Kräften unterworfen ist.

Eine besonders günstige Lösung sieht vor, dass der Dichtungskörper in dem zweiten Deformationszustand axial und radial beaufschlagt ist.

Eine andere vorteilhafte Lösung sieht vor, dass der Dichtungskörper in dem zweiten Deformationszustand ausschließlich axial beaufschlagt ist.

Vorzugsweise ist zur Beaufschlagung des Dichtungskörpers im zweiten Deformationszustand vorgesehen, dass dieser an beiden einander gegenüberliegenden Stirnseiten im Sinne einer Verkürzung eines Abstandes der Stirnseiten beaufschlagt ist.

Insbesondere ist vorzugsweise vorgesehen, dass der Dichtungskörper in dem zweiten Deformationszustand eine den Durchführungsquerschnitt relativ zum Durchführungsquerschnitt im ersten Deformationszustand verengende Innenkontur eines Durchführungskanals aufweist.

Insbesondere hat die Innenkontur dabei im zweiten Deformationszustand eine derartige Form, dass die Innenkontur jeweils ausgehend von Endöffnungen des Durchführungskanals zu einem Mittenbereich hin radial zur Mittelachse nach innen gewölbt ist.

Insbesondere ist vorgesehen, dass die Innenkontur im zweiten Deformationszustand eine torusähnliche Form aufweist.

Alternativ dazu sieht ein weiteres Ausführungsbeispiel vor, dass der Dichtungskörper im zweiten Deformationszustand eine Innenkontur aufweist, die im Bereich nahe von Endöffnungen des Durchführungskanals radial zur Mittelachse nach innen verengt ist.

Um zu erreichen, dass der Dichtungskörper sich definitiv in der gewünschten Weise unter Verengung des Durchführungsquerschnitts des Durchführungskanals verformt ist vorzugsweise vorgesehen, dass der Dichtungskörper auf seiner dem Durchführungskanal abgewandten Seite mindestens eine Ausnehmung aufweist.

Um zu erreichen, dass die Ausnehmung dazu beiträgt, eine definierte Verformung des Dichtungskörpers beim Übergang vom ersten in den zweiten Deformationszustand zu erreichen, ist vorzugsweise vorgesehen, dass die mindestens eine Ausnehmung einen freien größenvariablen Hohlraum bildet. Wenn das Druckelement in seiner Druckstellung mit dem Druckkörper in einer Druckkörperaufnahme des Gehäusestutzens angeordnet ist, kann beispielsweise das Druckelement nur den Druckkörper umfassen und somit in der Druckstellung vollständig in dem Gehäusestutzen angeordnet sein.

Es ist aber auch denkbar, dass das Druckelement beispielsweise noch einen Randbereich oder eine Abdeckung aufweist, mit welcher insbesondere eine Stirnseite des Gehäusestutzens abdeckbar ist.

Wenn das Druckelement durch die Druckelementaufnahme axial bewegbar geführt ist, wäre es theoretisch aber auch möglich, der axialen Bewegung des Druckelements noch eine rotatorische Bewegung zu überlagern.

Eine besonders vorteilhafte Lösung sieht jedoch vor, dass das Druckelement durch eine ausschließlich axiale Bewegung parallel zur Mittelachse in die Druckstellung bewegbar ist.

Vorzugsweise ist das mindestens eine Rastelement an dem Teilbereich des Druckkörpers angeordnet, der in der Druckstellung in der Druckkörperaufnahme sitzt.

Grundsätzlich ist es bei der Erfindung gemäß Anspruch 1 bis 5 denkbar, keine definierte Stellung des Druckelements vor Erreichen der Druckstellung vorzusehen, so dass das Druckelement zum Beaufschlagen des Dichtelements in den Gehäusestutzen eingreift und dann die Druckstellung erreicht, wobei eine Bewegung des Druckelements in Richtung parallel zur Mittelachse erforderlich ist.

Bei der Lösung, gemäß welcher das Druckelement in der Montagestellung durch mindestens ein Rastelement an dem Gehäusestutzen fixierbar ist, kann hierzu ein separates Rastelement vorgesehen sein, welches nicht identisch ist mit dem Rastelement, welches das Druckelement in der Druckstellung am Gehäusestutzen fixiert.

Hinsichtlich der Beaufschlagung des Dichtungskörpers im ersten Deformationszustand wurde lediglich festgelegt, dass diese derart sein soll, dass der Durchführungsquerschnitt größer ist als im zweiten Deformationszustand, dabei könnte prinzipiell bereits eine Beaufschlagung des Dichtungskörpers erfolgen, um den ersten Deformationszustand zu erreichen.

Prinzipiell kann der Dichtungskörper in dem zweiten Deformationszustand in mehreren Richtungen beaufschlagt sein.

So sieht beispielsweise eine Lösung vor, dass der Dichtungskörper in dem zweiten Deformationszustand radial beaufschlagt ist.

Wenn zur Beaufschlagung des Dichtungskörpers im zweiten Deformationszustand vorgesehen ist, dass dieser an beiden einander gegenüberliegenden Stirnseiten im Sinne einer Verkürzung eines Abstandes der Stirnseiten beaufschlagt ist, ist zur Differenzierung gegenüber dem ersten Deformationszustandes vorgesehen, dass ein Abstand voneinander gegenüberliegenden Stirnseiten des Dichtungskörpers im zweiten Deformationszustand geringer ist als im ersten Deformationszustand.

Wenn vorgesehen ist, dass der Dichtungskörper auf seiner dem Durchführungskanal abgewandten Seite mindestens eine Ausnehmung aufweist, kann die Ausnehmung in Umfangsrichtung unterbrochen sein und somit in Umfangsrichtung an mehreren aufeinanderfolgenden Stellen eine Ausnehmung vorgesehen sein.

Alternativ dazu ist vorgesehen, dass die mindestens eine Ausnehmung um den Dichtungskörper umlaufend ausgebildet ist, das heißt eine zusammenhängende und vorzugsweise geschlossen um den Dichtungskörper umlaufende Ausbildung aufweist.

Wenn die mindestens eine Ausnehmung einen freien größenvariablen Hohlraum bildet, ist insbesondere der Hohlraum im ersten Deformationszustand größer als im zweiten Deformationszustand, so dass durch Verringern des Hohlraums beim Übergang in den zweiten Deformationszustand die definierte Deformation des Dichtungskörpers erreicht ist.

Dabei könnte die mindestens eine Ausnehmung eine beliebige Form aufweisen.

Vorzugsweise ist dabei vorgesehen, dass die Ausnehmung eine Nut ist, welche beispielsweise um den Dichtungskörper umlaufend ausgebildet ist.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine perspektivische Darstellung eines Gehäuses mit einer erfindungsgemäßen Kabeldurchführung;
- Fig. 2: eine Explosionsdarstellung eines ersten Ausführungsbeispiels einer erfindungsgemäßen Kabeldurchführung;
- Fig. 3: eine Schnittdarstellung des ersten Ausführungsbeispiels der erfindungsgemäßen Kabeldurchführung mit in eine Dichtungsaufnahme eines Gehäusestutzens eingesetztem Dichtelement in einem ersten Deformationszustand;
- Fig. 4: eine Schnittdarstellung ähnlich Fig. 3 mit einer Kabeldurchführung und in einem zweiten Deformationszustand befindlichem Dichtelement;
- Fig. 5: eine perspektivische teilweise aufgeschnittene Darstellung eines Dichtelements eines zweiten Ausführungsbeispiels einer erfindungsgemäßen Kabeldurchführung;
- Fig. 6: eine Darstellung ähnlich Fig. 5 eines dritten Ausführungsbeispiels einer erfindungsgemäßen Kabeldurchführung;

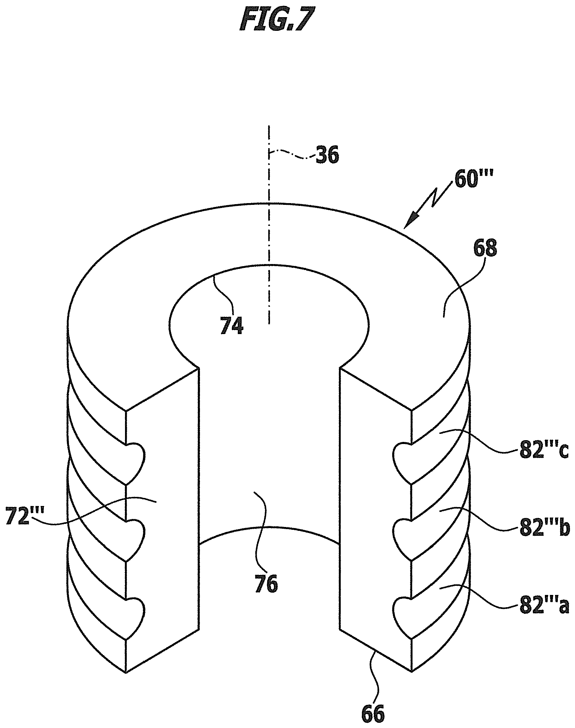

- Fig. 7: eine Darstellung ähnlich Fig. 5 eines vierten Ausführungsbeispiels einer erfindungsgemäßen Kabeldurchführung;
- Fig. 8: eine teilweise aufgeschnittene Darstellung eines fünften Ausführungsbeispiels einer erfindungsgemäßen Kabeldurchführung in Montagestellung;
- Fig. 9: eine Darstellung ähnlich Fig. 8 des fünften Ausführungsbeispiels in einer Druckstellung und
- Fig. 10: eine Darstellung ähnlich Fig. 8 eines sechsten Ausführungsbeispiels einer erfindungsgemäßen Kabeldurchführung.

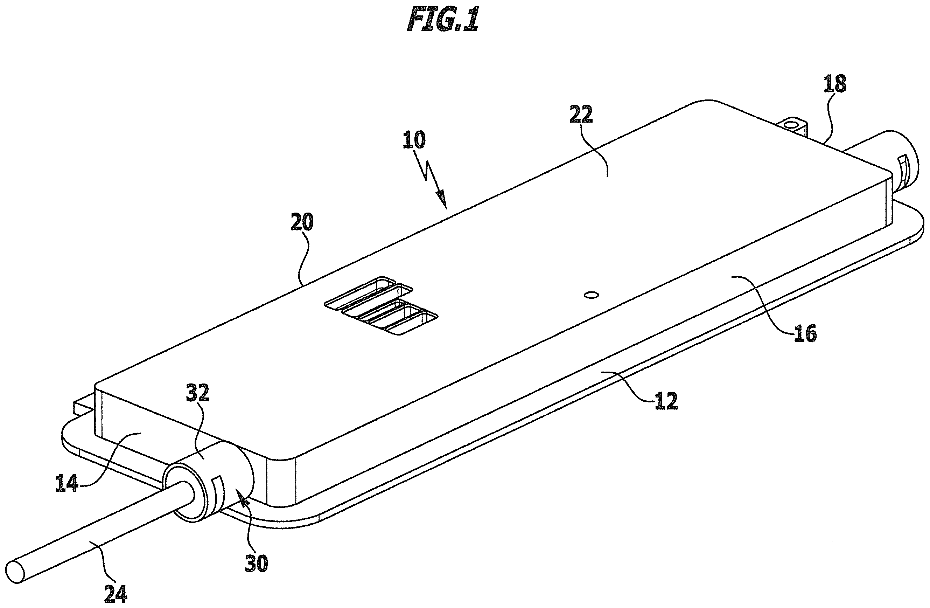

Ein in Fig. 1 dargestelltes und als Ganzes mit 10 bezeichnetes Gehäuse eines Geräts umfasst beispielsweise eine Gehäusebasis 12, über welcher sich Seitenwände 14, 16, 18 und 20 erheben, die einen der Gehäusebasis 12 gegenüberliegenden Gehäusedeckel 22 tragen.

Um in das Gehäuse 10 führende elektrische Kabel einführen zu können und außerdem einen dichten Abschluss zwischen den Kabeln 24 und dem Gehäuse 10 herstellen zu können, sind vorzugsweise an einer oder mehreren Seitenwänden als Ganzes mit 30 bezeichnete Kabeldurchführungen vorgesehen.

Ein erstes Ausführungsbeispiel einer derartige Kabeldurchführung 30, in Explosionsdarstellung dargestellt in Fig. 1, umfasst einen Gehäusestutzen 32, welcher fest mit dem Gehäuse 10, beispielsweise einem Wandabschnitt einer der Seitenwände 14, 16, 18 oder 20, verbunden ist.

Insbesondere umfasst der Gehäusestutzen 32 einen zu einer Mittelachse 36 zylindrisch ausgebildeten Hülsenkörper 34, welcher im Bereich eines ersten Endes 38 einen von dem zylindrischen Hülsenkörper 34 radial nach innen zur Mittelachse 36 verlaufenden Stützflansch 42 aufweist, welcher somit radial nach innen über eine Innenwandfläche 44 des Hülsenkörpers 34 übersteht und einen Durchlass 46 umschließt.

Beispielsweise ist der Gehäusestutzen 34 im Bereich seines ersten Endes 38, vorzugsweise mittels des Stützflansches 42, mit dem Gehäuse 10, beispielsweise der Seitenwand 14, stoffschlüssig, insbesondere durch Kleben oder Löten, verbunden.

Ausgehend von dem Stützflansch 42 erstreckt sich die Innenwandfläche 44 bis zu einem zweiten Ende 48 des Gehäusestutzens 32 und endet im Bereich einer Stutzenöffnung 52 am zweiten Ende 48.

Durch die Stutzenöffnung 52 ist ein als Ganzes mit 60 bezeichnetes Dichtelement in einen Innenraum 62 des Gehäusestutzens 32 einsetzbar, und zwar so weit einsetzbar, dass dieses in einer im Innenraum 62 des Gehäusestutzens 32 vorgesehenen Dichtungsaufnahme 64 angeordnet ist, welche sich ausgehend von dem Stützflansch 42 in Richtung der Stutzenöffnung 52 erstreckt, jedoch im Abstand von der Stutzenöffnung endet.

Ein in dieser Dichtungsaufnahme 64 sitzendes Dichtungselement 60 sitzt dabei mit einer unteren Stirnseite 66 auf dem Stützflansch 42 auf und erstreckt sich bis zu einer oberen Stirnseite 68, welche der Stutzenöffnung 52 zugewandt ist.

Zwischen der unteren Stirnseite 66 des Dichtelements 60 und der oberen Stirnseite 68 des Dichtelements 60 erstreckt sich ein elastisch deformierbarer Dichtungskörper 72 des Dichtelements 60, der ringförmig einen Durchführungskanal 74 umschließt, welche sich zwischen an den Stirnseiten 66, 68 angeordneten Endöffnungen 67, 69 erstreckt.

In einem einer Herstellungsform entsprechenden Ausgangszustand des Dichtungskörpers 72 weist der Durchführungskanal 74 beispielsweise eine zylindrisch zur Mittelachse 36 verlaufende Innenfläche 76 auf, welche den Durchführungskanal 74 bildet.

Der Dichtungskörper 72 ist vorzugsweise ohne Deformation des Ausgangszustandes in die Dichtungsaufnahme 64 einsetzbar, wobei eine zylindrische Außenfläche 78 des Dichtungskörpers 72 beispielsweise an der Innenwandfläche 44 des Gehäusestutzens 32 im Bereich der Dichtungsaufnahme 64 anliegt.

Der Dichtungskörper 72 ist ferner mit einer sich von der Außenfläche 78 in den Dichtungskörper 72 hineinerstreckenden umlaufenden Nut 82 versehen, welche vorzugsweise in einem mittigen Bereich zwischen der unteren Stirnseite 66 und der oberen Stirnseite 68 des Dichtelements 60 und somit auch des Dichtungskörpers 72 angeordnet ist und beispielsweise einen dreieckähnlichen Querschnitt aufweist.

Der mittige Bereich ist insbesondere durch ein mittiges Segment definiert, wenn man den Dichtungskörper 72 zwischen den Stirnseiten 66 und 68 in drei sich in Richtung der Mittelachse 36 jeweils über dieselbe Distanz erstreckende Segmente unterteilt.

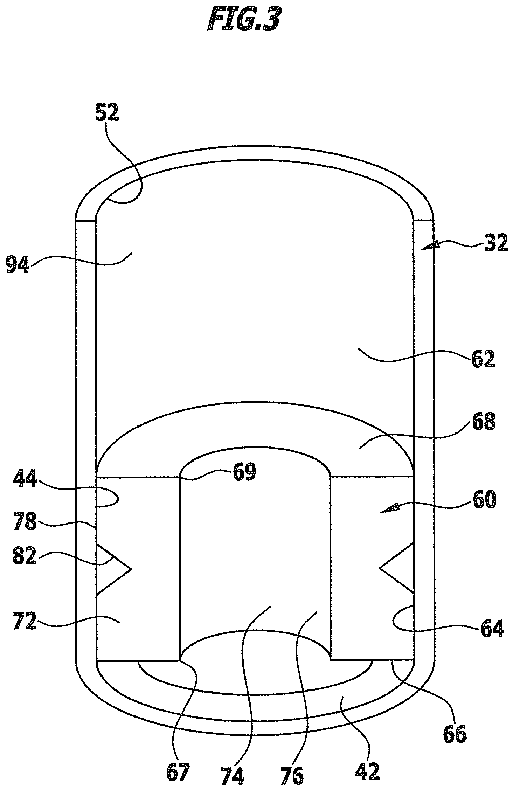

In dem in Fig. 3 dargestellten undeformierten Ausgangszustand des Dichtungskörpers hat die Nut 82 den maximalen Nutquerschnitt und die Innenflächen 76 verlaufen vorzugsweise zylindrisch zur Mittelachse 36.

Mit diesem undeformierten Ausgangszustand weist beispielsweise auch der Durchführungskanal 74 an jeder Stelle die maximale Querschnittsfläche auf, so dass durch den Durchführungskanal 74 des Dichtungskörpers 72 ein kleiner als dessen Querschnittsfläche dimensioniertes Kabel 24 hindurchgeschoben werden kann, um dieses Kabel 24 in einen Innenraum des Gehäuses 10 einzuführen und dort an in dem Gehäuse 10 vorgesehene elektrische Verbindungen anzuschließen.

Der undeformierte Ausgangszustand des den Dichtungskörper 72 umfassenden Dichtelements 60 wird beispielsweise als erster Deformationszustand bezeichnet.

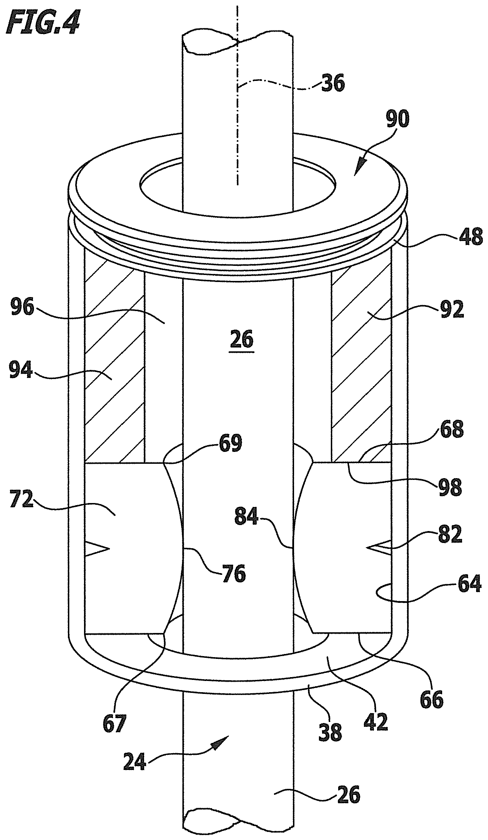

Um nach Durchführen des Kabels 24 durch den Durchführungskanal 74 im Dichtungskörper 72 einen dichten Abschluss mit dem Dichtungskörper 72 herstellen zu können, ist, wie in Fig. 3 und Fig. 4 dargestellt, der Dichtungskörper 72 deformierbar und zwar durch eine Beaufschlagung der Stirnseiten 66 und 68 derart, dass diese unter Deformation des Dichtungskörpers 72 aufeinander zu bewegt werden und somit die Ausdehnung des Dichtungskörpers 72 in Richtung parallel zur Mittelachse 36 und folglich auch der Abstand der Stirnseiten 66 und 68 voneinander reduziert wird.

Dies führt einerseits dazu, dass sich der Querschnitt der Nut 82 verringert und dass sich andererseits die Innenfläche 76 torusähnlich verformt, das heißt im zur Mittelachse 36 parallelen Querschnitt gesehen, zwischen der unteren Stirnseite 66 und der oberen Stirnseite 68 konvex nach Innen in Richtung auf eine Mantelfläche 26 des Kabels 24 gewölbt ist und somit zumindest mit einem maximal radial nach innen auf die Mittelachse 36 zu aufgewölbten Bereich 84 kraftbeaufschlagt an der Mantelfläche 26 des Kabels 24 anliegt und somit mit dieser einen dichten Abschluss bildet, wie in Fig. 4 dargestellt.

Gleichzeitig stützt sich dabei der Dichtungskörper 72 an der Innenwandfläche 44 des Gehäusestutzens 32 ab und bildet mit seiner Außenfläche 78 einen dichten Abschluss mit der Innenwandfläche 44 des Gehäusestutzens 32, so dass insgesamt durch den Dichtungskörper 72 eine dichte Verbindung zwischen der Mantelfläche 26 des Kabels 24 und dem Gehäusestutzen 32 hergestellt ist, der ein Eindringen von Feuchtigkeit und Schmutz von einer Umgebung des Gehäuses 10 in den Innenraum des Gehäuses 10 verhindert.

Um den Dichtungskörper 72 des Dichtelements 60 in den zweiten Deformationszustand überführen und in diesem halten zu können, ist das in der Dichtungsaufnahme 64 angeordnete Dichtelement 60 durch ein als Ganzes mit 90 bezeichnetes Druckelement beaufschlagbar, welches einen Druckkörper 92 aufweist, der in eine im Innenraum 62 vorgesehene und sich zwischen der Dichtungsaufnahme 64 und der Stutzenöffnung 52 erstreckende Druckkörperaufnahme 94 des Gehäusestutzens 32 durch die Stutzenöffnung 52 hindurch einsetzbar ist und einen Kabeldurchlass 96 aufweist, welcher koaxial zu dem Durchführungskanal 74 des Dichtelements 60 angeordnet ist und vorzugsweise eine gleich große oder eine größere Querschnittsfläche hat als der Durchführungskanal 74 des Dichtelements 60 im ersten Deformationszustand.

Der Druckkörper 92 ist, wie in Fig. 4 dargestellt, in der Lage, mit einer insbesondere ringförmig ausgebildeten Druckseite 98 die obere Stirnseite 68 des Dichtelements 60 so zu beaufschlagen und somit so zu deformieren, dass das Dichtelement 60 im zweiten Deformationszustand zwischen dem Stützflansch 42 und des Gehäusestutzens 32 und der Druckseite 98 des Druckkörpers 92 eingespannt und dadurch in Richtung parallel zur Mittelachse 36 in einem axial deformierten Zustand gehalten ist, der - wie bereits beschrieben - zur Abdichtung zwischen dem Gehäusestutzen 32 und der Mantelfläche 26 des Kabels 24 führt.

Zur Positionierung des Druckkörpers 92 in der das Dichtelement 60 im zweiten Deformationszustand haltenden Druckstellung in der Druckkörperaufnahme 64 ist der Druckkörper 92 mit Rastelementen 102, beispielsweise einander gegenüberliegend am Druckkörper 92 angeordneten Rastelementen 102, versehen, die eine quer zur Mittelachse 36 verlaufende Rastfläche 104 aufweisen, wobei die Rastfläche 104 radial außenliegend zu einer Außenfläche 106 des Druckkörpers 92 angeordnet ist, wenn die Rastelemente 102 in ihrer Raststellung stehen.

Die Rastfläche 104 der Rastelemente 102 ist dabei auf einer der Druckseite 98 des Druckkörpers 92 abgewandten Seite der Rastelemente 102 angeordnet. Insbesondere hat die Rastfläche 104 die Aufgabe, den Druckkörper 92 dann, wenn dieser in der Druckkörperaufnahme 94 im Gehäusestutzen 32 sitzt, gegen eine Bewegung in Richtung von dem Druckelement 60 weg zu sichern.

Ferner verläuft zwischen der Rastfläche 104 und der Außenfläche 106 eine Auflaufschräge 108 der Rastelemente 102, welche sich ausgehend von der Rastfläche 104 in Richtung der Druckseite 98 des Druckkörpers 92 erstreckt und in der Raststellung von einem Außenrand 112 der Rastfläche 104 zur Außenfläche 106 hin abfällt.

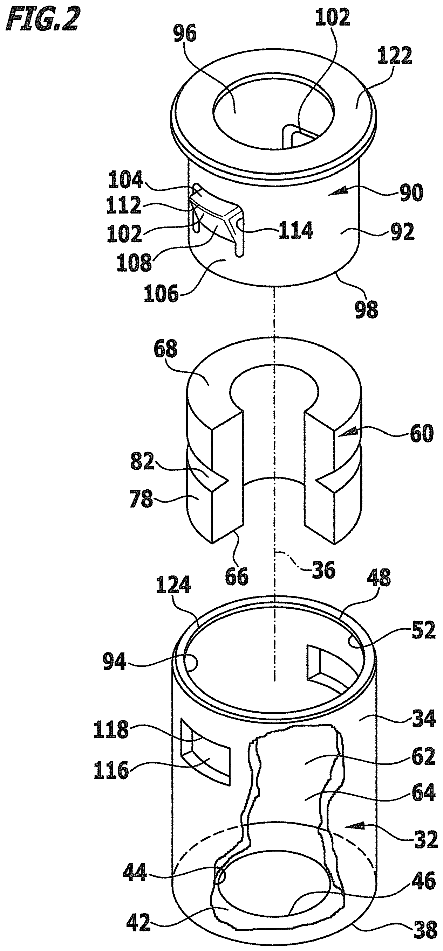

Die Rastelemente 102 sind, wie in Fig. 2 dargestellt, einstückig an den Druckkörper 92 angeformt, jedoch lediglich auf der Seite, an welcher die Auflaufschräge 108 in die Außenfläche 106 des Druckkörpers 92 übergeht, federelastisch mit dem Druckkörper 92 verbunden, an allen übrigen Seiten jedoch mittels einer Durchbrechung 114 relativ zum Druckkörper 92 freigestellt, so dass die Rastelemente 102 mit der Rastfläche 104 soweit federelastisch relativ zum Druckkörper 92 bewegbar sind, dass die Rastfläche 104 in dem radial beaufschlagten Zustand der Rastelemente 102 radial innerhalb der Außenfläche 106 des Druckkörpers 92 liegen.

Wird nun der Druckkörper 92 durch die Stutzenöffnung 52 in den Innenraum 62 des Gehäusestutzens 32 eingeschoben um die Druckkörperaufnahme 94 zu erreichen, so kommt die Stutzenöffnung 52 in Berührung mit den Auflaufschrägen 108 und bewirkt bei weiterem Einschieben des Druckkörpers 92 in den Gehäusestutzen 32 die Bewegung der Rastelemente 102 radial in Richtung zur Mittelachse 36, so dass die Rastflächen 104 sich ebenfalls radial zur Mittelachse 36 hin bewegen und eine Position einnehmen, in welcher diese radial soweit nach innen bewegt sind, dass die Rastelemente 102 mit dem Außenrand 112 an der Innenwandfläche 44 des Gehäusestutzens 32 anliegen.

Ein weiteres Einschieben des Druckkörpers 92 bewirkt ferner, dass die Rastelemente 102 eine Position erreichen, in welcher diese fensterähnlichen Ausschnitten 116 im Gehäusestutzen 32 gegenüberliegen. Ist dies der Fall, so können sich die federelastisch in Richtung der Mittelachse 36 bewegten Rastelemente 104 wieder radial nach außen in die Ausschnitte 116 hinein bewegen und mit den Rastflächen 104 Kantenflächen 118 der Ausschnitte 116 hintergreifen und dadurch die Druckkörper 92 gegen eine Bewegung in Richtung weg von dem deformierten Dichtelement 60 sichern.

Dabei sind die Ausschnitte 116 so angeordnet, dass die Rastelemente 102 mit den Rastflächen 104 die Kantenflächen 118 dann hintergreifen, wenn der Druckkörper 92 gleichzeitig das Dichtelement 60, insbesondere den Dichtungskörper 72, in dem zweiten Deformationszustand hält, so dass die Rastelemente 102 durch Eingreifen in die Ausschnitte 116 die das Dichtelement 60 im zweiten deformierten Zustand haltende Stellung dauerhaft sichern.

Ferner ist der Druckkörper 92 des Druckelements 90 vorzugsweise noch mit einem Abdeckflansch 122 versehen, welcher radial über die Außenfläche 106 des Druckkörpers 92 übersteht und in der Druckstellung des Druckkörpers 92 in unmittelbarem Anschluss an die Stutzenöffnung 52 den Gehäusestutzen 32 im Bereich seiner am zweiten Ende 48 liegenden Stirnseite 124 übergreift.

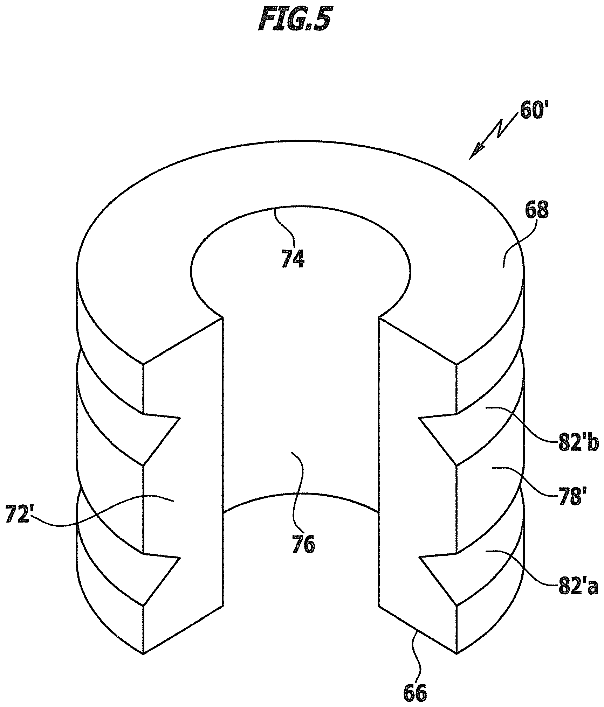

Bei einem zweiten Ausführungsbeispiel einer erfindungsgemäßen Kabeldurchführung, dargestellt in Fig. 5, ist das Dichtelement 60' so ausgebildet, dass ausgehend von der Außenfläche 78' sich zwei Nuten 82'a und 82'b in den Dichtungskörper 72' hinein erstrecken.

Beispielsweise ist die Nut 82'a im selben Abstand von der Stirnseite 66 des Dichtungskörpers 72 angeordnet wie die Nut 82'b von der Stirnseite 68.

Das Vorsehen der beiden Nuten 82'a und 82'b verbessert noch das Aufwölbverhalten der Innenfläche 76 beim Deformieren des Dichtungskörpers 72', so dass dieser eine noch stärkere Aufwölbung um zweiten Deformationszustand aufweist.

Ferner sind die weiteren Elemente mit denen des ersten Ausführungsbeispiels der erfindungsgemäßen Kabeldurchführung 30 identisch, so dass vollinhaltlich auf die Ausführungen zum ersten Ausführungsbeispiel verwiesen werden kann.

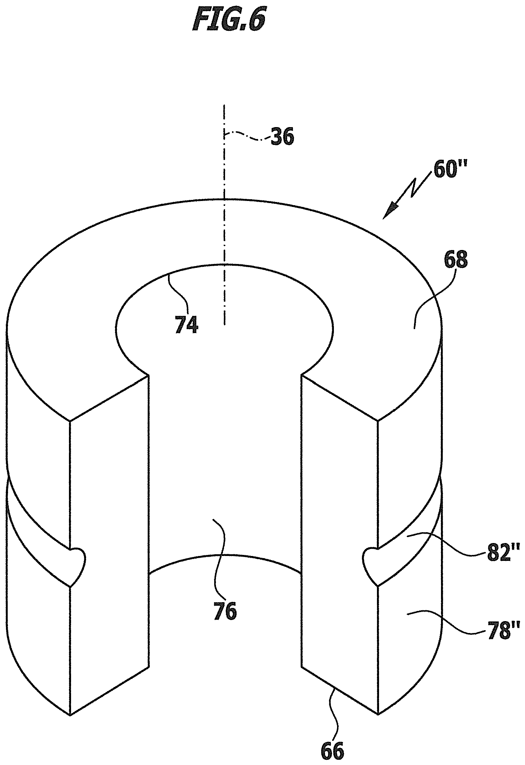

Bei einem dritten Ausführungsbeispiel einer erfindungsgemäßen Kabeldurchführung, dargestellt in Fig. 6, ist das Dichtelement 60" nicht mit der Nut 82 mit einem im Wesentlichen dreieckförmigen Querschnitt ausgebildet, sondern mit einer Nut 82", welche einen U-förmigen Querschnitt aufweist.

Die Nut 82" liegt dabei ebenfalls in dem mittigen Bereich des Dichtungskörpers 72, wie im Zusammenhang mit dem ersten Ausführungsbeispiel erläutert.

Im Übrigen wird hinsichtlich der weiteren Elemente des dritten Ausführungsbeispiels der erfindungsgemäßen Kabeldurchführung vollinhaltlich auf die Ausführungen zum ersten Ausführungsbeispiel Bezug genommen.

Bei einem vierten Ausführungsbeispiel einer erfindungsgemäßen Kabeldurchführung ist das Dichtelement 60"' mit insgesamt drei Nuten 82"'a, 82"'b und 82"'c versehen, wobei die Nut 82"'a denselben Abstand von der Stirnseite 66 aufweist wie die Nut 82"'c von der Stirnseite 68 und die Nut 82"'b in einem mittigen Bereich zwischen den Stirnseiten 66 und 68 liegt, wie bereits im Zusammenhang mit dem ersten Ausführungsbeispiel definiert wurde.

Das Vorsehen der drei Nuten verbessert noch weiter das Deformationsverhalten des Dichtungskörpers 72"', so dass dieser sich beim Übergang vom ersten Deformationszustand in den zweiten Deformationszustand noch stärker in Richtung der Mittelachse 36 auswölbt, um einen dichten Abschluss zwischen der Mantelfläche 26 des Kabels 24 und dem Dichtungskörper 72"' zu erreichen.

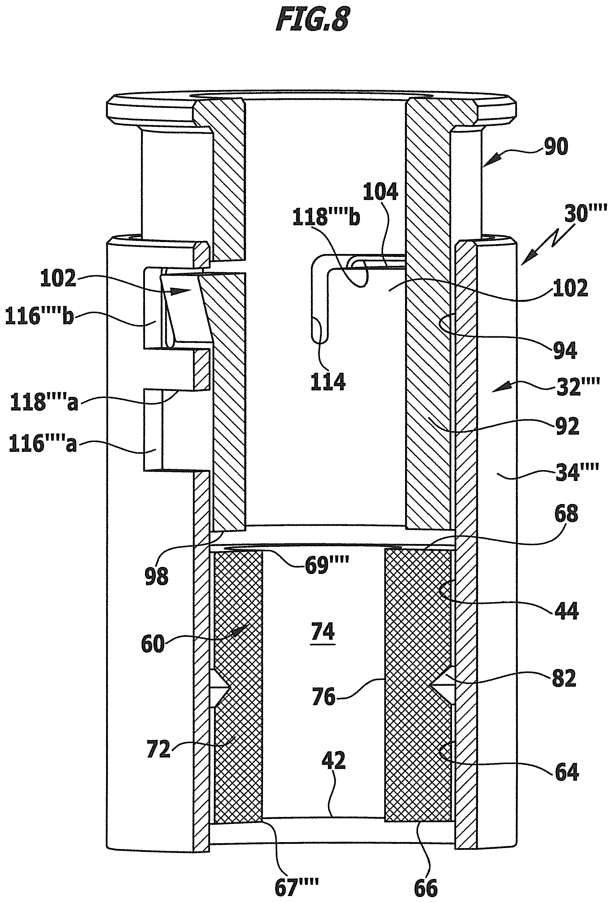

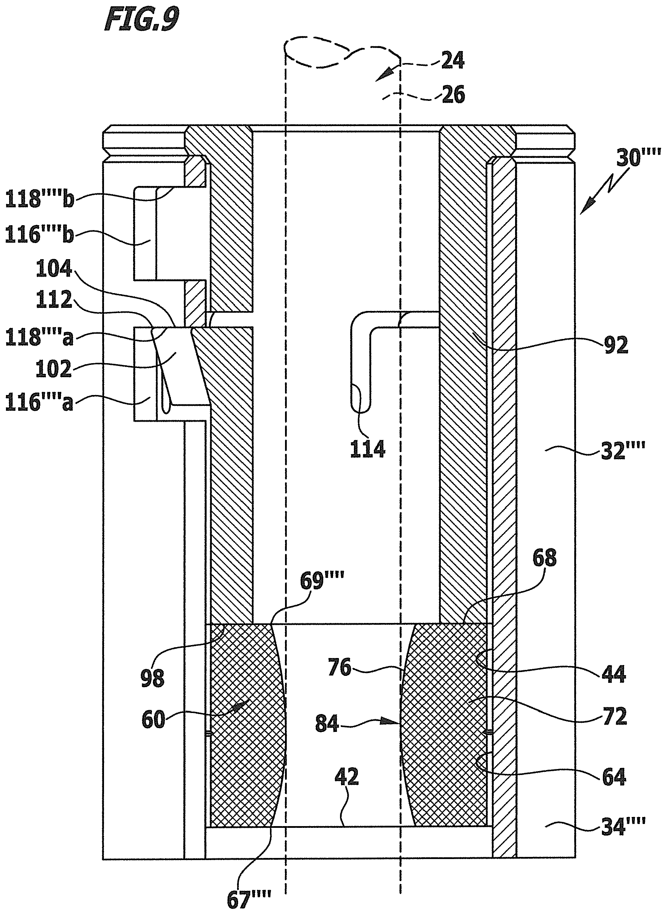

Bei einem fünften Ausführungsbeispiel einer erfindungsgemäßen Kabeldurchführung 30"", dargestellt in den Fig. 8 und 9 ist das Dichtelement 72 in gleicher Weise ausgebildet wie beim ersten Ausführungsbeispiel, so dass diesbezüglich vollinhaltlich auf die Ausführungen zum ersten Ausführungsbeispiel verwiesen werden kann.

Des Weiteren ist auch der Gehäusestutzen 32 insoweit als der Stützflansch 42 und die Dichtungsaufnahme 64 betroffen sind, in gleicher Weise ausgebildet wie beim ersten Ausführungsbeispiel, allerdings mit dem Unterschied, dass der Hülsenkörper 34"" zwei Ausschnitte 116""a und 116""b aufweist, die in unterschiedlichen Abständen von dem Stützflansch 42 angeordnet sind.

Insbesondere ist der Ausschnitt 116""b, wie in Fig. 8 dargestellt, in einem derartigen Abstand von dem Stützflansch 42 angeordnet, dass dieser dann, wenn das Rastelement 102 in den Ausschnitt 116""b eingreift, der Druckkörper 92 nicht in seiner Druckstellung steht, sondern in einer Montagestellung, in welcher der Druckkörper 92 mit der Druckseite 98 den Dichtungskörper 72 des Dichtelements 60 nicht beaufschlagt, sondern vorzugsweise in einem geringen Abstand von der Stirnseite 68 steht, äußerstenfalls die Stirnseite 68 mit der Druckseite 98 berührt, ohne den Dichtungskörper 72 zu deformieren.

In dieser Montagestellung des Druckkörpers 92 greift dieser bereits in die Druckkörperaufnahme 94 ein, so dass bereits ein Festlegen des Druckelements 90 relativ zu dem Gehäusestutzen 32"" möglich ist.

Ferner wird durch diese Montagestellung des Druckelements 90 auch das Dichtelement 60 in der Dichtungsaufnahme 64 innerhalb des Gehäusestutzens 32 gehalten, so dass das Kabel 24 durch den Kabeldurchlass 96 des Druckelements 90 hindurchgeschoben werden kann und außerdem auch durch den Durchführungskanal 74 des Dichtelements 60 frei hindurchgeschoben werden kann.

Nach Durchschieben des Kabels 24 kann der Druckkörper 92 von der in Fig. 8 dargestellten Montagestellung in die in Fig. 9 dargestellte Druckstellung bewegt werden, wobei bei dieser Bewegung des Druckkörpers 92 eine Deformation des Dichtungskörpers 72 erfolgt, wie in Fig. 9 dargestellt, bei welcher die Innenfläche 76 die bereits im Zusammenhang mit dem ersten Ausführungsbeispiel beschriebene torusähnliche Form einnimmt, und einen gewölbten Bereich 84 ausbildet, welche eine Abdichtung zu der Mantelfläche 26 des Kabels bewirkt.

In dieser Druckstellung greift das Rastelement 102 des Druckkörpers in den Ausschnitt 116""a ein, der derart positioniert ist, wie im Zusammenhang mit dem ersten Ausführungsbeispiel beschrieben, dass die Rastfläche 104 die Kantenfläche 118 des Ausschnitts 116""a hintergreift und somit den Druckkörper 92 in der Druckstellung fixiert.

Somit liegt eine Abdichtung eines Kabels 24 in gleicher Weise vor, wie im Zusammenhang mit dem ersten Ausführungsbeispiel beschrieben.

Bei den weiteren Merkmalen des fünften Ausführungsbeispiels sind dieselben Bezugszeichen wie bei den vorausgehenden Ausführungsbeispielen verwendet, so dass auf diese vollinhaltlich Bezug genommen werden kann.

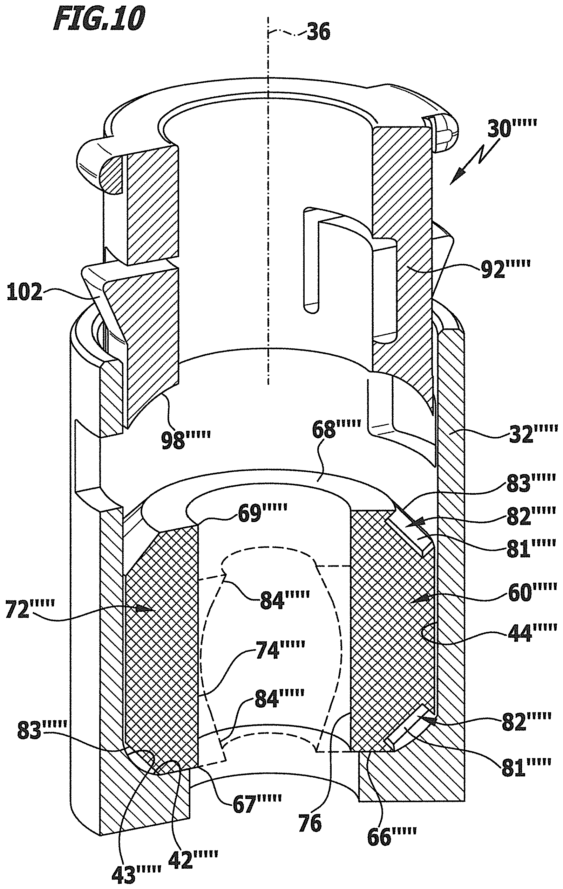

Bei einem sechsten Ausführungsbeispiel einer erfindungsgemäßen Kabeldurchführung 30""', dargestellt in Fig. 10 ist das Dichtelement 60""' so ausgebildet, dass dieses einen Dichtkörper 72""' mit einer unteren Stirnseite 66""' und einer oberen Stirnseite 68""' aufweist, an welche radial außenliegend jeweils die Ausnehmungen 82""' angrenzen, welche eine radial außenliegende konischen Außenkontur 83""' mit zusätzlichen von der konischen Außenkontur 83""' sich noch in den Dichtungskörper 72""' hineinerstreckenden Taschen 81""' ergeben. Dabei ist der in Fig. 10 durchgezogen dargestellte Zustand der erste Deformationszustand.

Diese Außenkontur 83""' führt dazu, dass im zweiten Deformationszustand, in Fig. 10 gestrichelt dargestellt, des Dichtelements 60""' dieses jeweils im Bereich der Stirnseiten 66""' und 68""' radial nach innen gedrückte Bereiche 84""' ausbildet, die sich dichtend an die Mantelfläche 26 eines durchgeführten Kabels 24 anlegen, um einen dichten Abschluss zu gewährleisten.

Um die Bildung der radial nach innen gedrückten Bereiche 84""' jeweils im Anschluss an die Stirnseiten 66""' und 68""' zu unterstützen, ist vorzugsweise der Stützflansch 42""' des Gehäusestutzens 32""' im Anschluss an die Innenwandfläche 44""' mit einer schräg zur Mittelachse 36 oder vorzugsweise konkav gerundet verlaufenden Übergangsfläche 43""' versehen, welche im zweiten Deformationszustand, in Fig. 10 gestrichelt dargestellt, das radiale nach innen Schieben des sich an die untere Stirnseite 55 angrenzenden Teilbereichs des Dichtungskörpers 72 unterstützt.

In gleicher Weise sind die Druckseiten 98""' des Druckkörpers 92""' schräg, vorzugsweise konkav gewölbt zur Mittelachse 36 ausgebildet, um ebenfalls ein radiales nach innen Schieben des sich an die obere Stirnseite 68""' anschließenden Teilbereichs des Dichtungskörpers 72 radial zur Mittelachse 36 zu erreichen, um den innen gedrückten Bereich 84""' im Anschluss an die Stirnseite 68""' im zweiten Deformationszustand zu erzeugen.

## Patentansprüche

1. Kabeldurchführung (30) für ein Schalt- oder Gerätegehäuse (10), umfassend einen an einem Wandabschnitt (14) des Schalt- oder Gerätegehäuses (10) fixierbaren Gehäusestutzen (32), der einen zylindrisch zu einer Mittelachse (36) ausgebildeten und sich in Richtung einer Mittelachse (36) erstreckenden Hülsenkörper (34) aufweist, eine in dem Gehäusestutzen (32) vorgesehene Dichtungsaufnahme (64), ein in der Dichtungsaufnahme (64) angeordnetes Dichtelement (60) mit einem deformierbaren Dichtungskörper (72) und mit einem den Dichtungskörper (72) in Richtung der Mittelachse (36) durchsetzenden Durchführungskanal (74), der in einem ersten Deformationszustand des Dichtungskörpers (72) einen größeren Durchführungsquerschnitt aufweist als in einem zweiten Deformationszustand, und ferner umfassend ein einen Druckkörper (92) aufweisendes Druckelement (90) zur Überführung des Dichtungskörpers (72) von dem ersten Deformationszustand in den zweiten Deformationszustand,
welches an dem Gehäusestutzen (32) axial verschiebbar geführt ist, welches in seiner den Dichtungskörper (72) im zweiten Deformationszustand haltenden Druckstellung an dem Gehäusestutzen (32) festgelegt ist, und welches mit mindestens einem Rastelement (102) versehen ist, welches seinerseits in der Druckstellung in eine verrastende Stellung bringbar ist und in der verrastenden Stellung in eine Ausnehmung (116) in dem Gehäusestutzen (32) eingreift,
**dadurch gekennzeichnet, dass** das Rastelement (102) dadurch radial bewegbar ist, dass es einstückig an den Druckkörper (92) angeformt, jedoch lediglich auf der Seite, an welcher eine Auflaufschräge (108) in eine Außenfläche (106) des Druckkörpers (92) übergeht, federelastisch mit dem Druckkörper (92) verbunden ist und an allen übrigen Seiten jedoch mittels einer Durchbrechung (114) relativ zum Druckkörper (92) freigestellt ist.

2. Kabeldurchführung nach Anspruch 1, **dadurch gekennzeichnet, dass** das Druckelement (90) in seiner Druckstellung mit einem auf das Dichtelement (60) einwirkenden Druckkörper (92) in dem Gehäusestutzen (32) sitzt.

3. Kabeldurchführung nach Anspruch 1 oder 2, **dadurch gekennzeichnet, dass** das Druckelement (90) in seiner Druckstellung mit dem Druckkörper (92) in einer Druckkörperaufnahme (94) des Gehäusestutzens (32) angeordnet ist.

4. Kabeldurchführung nach einem der voranstehenden Ansprüche, **dadurch gekennzeichnet, dass** das Druckelement (90) durch die Druckkörperaufnahme (94) axial bewegbar geführt ist.

5. Kabeldurchführung nach einem der voranstehenden Ansprüche, **dadurch gekennzeichnet, dass** das Druckelement (90) mit mehreren Rastelementen (102) versehen ist.

6. Kabeldurchführung nach einem der voranstehenden Ansprüche, **dadurch gekennzeichnet, dass** das Druckelement (90"") an dem Gehäusestutzen (32"") in einer Montagestellung positionierbar ist, in welcher dieses den Dichtungskörper (72) in dem ersten Deformationszustand belässt, und dass insbesondere das Druckelement (90"") in der Montagestellung durch mindestens ein Rastelement (102) an dem Gehäusestutzen (32"") fixiert ist.

7. Kabeldurchführung nach einem der voranstehenden Ansprüche, **dadurch gekennzeichnet, dass** der Dichtungskörper (72) in dem ersten Deformationszustand axial unbeaufschlagt ist.

8. Kabeldurchführung nach einem der voranstehenden Ansprüche, **dadurch gekennzeichnet, dass** der Dichtungskörper (72) in dem ersten Deformationszustand eine Form aufweist, die seiner Herstellungsform entspricht.

9. Kabeldurchführung nach einem der voranstehenden Ansprüche, **dadurch gekennzeichnet, dass** der Dichtungskörper (72) in dem zweiten Deformationszustand axial und radial beaufschlagt ist.

10. Kabeldurchführung nach einem der Ansprüche 1 bis 8, **dadurch gekennzeichnet, dass** der Dichtungskörper (72) in dem zweiten Deformationszustand ausschließlich axial beaufschlagt ist.

11. Kabeldurchführung nach einem der voranstehenden Ansprüche, **dadurch gekennzeichnet, dass** der Dichtungskörper (72) im zweiten Deformationszustand an beiden einander gegenüberliegenden Stirnseiten (66, 68) im Sinne einer Verkürzung eines Abstandes der Stirnseiten (66, 68) beaufschlagt ist.

12. Kabeldurchführung nach einem der voranstehenden Ansprüche, **dadurch gekennzeichnet, dass** der Dichtungskörper (72) in dem zweiten Deformationszustand eine den Durchführungsquerschnitt relativ zum Durchführungsquerschnitt im ersten Deformationszustand verengende Innenkontur (76) eines Durchführungskanals (74) aufweist.

13. Kabeldurchführung nach Anspruch 12, **dadurch gekennzeichnet, dass** sich im zweiten Deformationszustand die Innenkontur (76) jeweils ausgehend von Endöffnungen (67, 69) des Durchführungskanals (74) zu einem Mittenbereich (84) hin radial nach innen wölbt und dass insbesondere die Innenkontur (76) im zweiten Deformationszustand eine torusähnliche Form aufweist.

14. Kabeldurchführung nach Anspruch 12, **dadurch gekennzeichnet, dass** der Dichtungskörper (72""') im zweiten Deformationszustand eine Innenkontur (78""') aufweist, die im Bereich nahe von Endöffnungen (67""', 69""') des Durchführungskanals (74""') radial zur Mittelachse (36) nach innen verengt ist.

15. Kabeldurchführung nach einem der voranstehenden Ansprüche, **dadurch gekennzeichnet, dass** der Dichtungskörper (72) auf seiner dem Durchführungskanal (74) abgewandten Seite mindestens eine Ausnehmung (82) aufweist.

16. Kabeldurchführung nach Anspruch 15, **dadurch gekennzeichnet, dass** die mindestens eine Ausnehmung (82) einen freien größenvariablen Hohlraum bildet.

## Claims

1. Cable feedthrough (30) for a switch or device housing (10), comprising a housing connection piece (32) securable to a wall section (14) of the switch or device housing (10), said connection piece having a sleeve member (34) formed cylindrically to a central axis (36) and extending in the direction of a central axis (36), a seal receptacle (64) provided in the housing connection piece (32), a sealing element (60) arranged in the seal receptacle (64) and having a deformable sealing member (72) and a feedthrough channel (74) passing through the sealing member (72) in the direction of the central axis (36), said channel having a feedthrough cross section greater in a first deformation state of the sealing member (72) than in a second deformation state, and, in addition, comprising a pressure element (90) with a pressure member (92) for transferring the sealing member (72) from the first deformation state into the second deformation state,
said pressure element being guided on the housing connection piece (32) for axial displacement, fixed on the housing connection piece (32) in its pressure position holding the sealing member (72) in the second deformation state and being provided with at least one snap-in element (102), said element, for its part, capable of being brought into a locking position in the pressure position and engaging in a recess (116) in the housing connection piece (32) in the locking position,
**characterized in that** the snap-in element (102) is radially movable **in that** it is integrally formed in one piece on the pressure member (92), is connected to the pressure member (92) in an elastic manner but only on the side where a run-on chamfer (108) merges into an outer surface (106) of the pressure member (92) and is, however, free on all the other sides relative to the pressure member (92) due to an opening (114).

2. Cable feedthrough as defined in claim 1, **characterized in that** in its pressure position the pressure element (90) is seated in the housing connection piece (32) with a pressure member (92) acting on the sealing element (60).

3. Cable feedthrough as defined in claim 1 or 2, **characterized in that** in its pressure position the pressure element (90) is arranged with the pressure member (92) in a pressure member receptacle (94) of the housing connection piece (32).

4. Cable feedthrough as defined in any one of the preceding claims, **characterized in that** the pressure element (90) is guided by the pressure member receptacle (94) for axial movement.

5. Cable feedthrough as defined in any one of the preceding claims, **characterized in that** the pressure element (90) is provided with several snap-in elements (102).

6. Cable feedthrough as defined in any one of the preceding claims, **characterized in that** the pressure element (90"") is positionable on the housing connection piece (32"") in an assembly position, the pressure element, in said position, leaving the sealing member (72) in the first deformation state, and that the pressure element (90"") is fixed on the housing connection piece (32"") in the assembly position, in particular, by at least one snap-in element (102).

7. Cable feedthrough as defined in any one of the preceding claims, **characterized in that** in the first deformation state the sealing member (72) is not acted upon axially.

8. Cable feedthrough as defined in any one of the preceding claims, **characterized in that** in the first deformation state the sealing member (72) has a shape corresponding to its production shape.

9. Cable feedthrough as defined in any one of the preceding claims, **characterized in that** in the second deformation state the sealing member (72) is acted upon axially and radially.

10. Cable feedthrough as defined in any one of claims 1 to 8, **characterized in that** in the second deformation state the sealing member (72) is acted upon only axially.

11. Cable feedthrough as defined in any one of the preceding claims, **characterized in that** in the second deformation state the sealing member (72) is acted upon at both end faces (66, 68) located opposite one another in the sense of shortening the distance between the end faces (66, 68).

12. Cable feedthrough as defined in any one of the preceding claims, **characterized in that** in the second deformation state the sealing member (72) has an inner contour of a feedthrough channel (74) narrowing the feedthrough cross section relative to the feedthrough cross section in the first deformation state.

13. Cable feedthrough as defined in claim 12, **characterized in that** in the second deformation state the inner contour (76) curves radially inwards towards a central area (84) proceeding from respective end openings (67, 69) of the feedthrough channel (74) and that the inner contour (76) has a torus-like shape, in particular, in the second deformation state.

14. Cable feedthrough as defined in claim 12, **characterized in that** in the second deformation state the sealing member (72""') has an inner contour (78""') narrowing inwards radially to the central axis (36) in the region close to end openings (67""', 69""') of the feedthrough channel (74'"").

15. Cable feedthrough as defined in any one of the preceding claims, **characterized in that** the sealing member (72) has at least one recess (82) on its side facing away from the feedthrough channel (74).

16. Cable feedthrough as defined in claim 15, **characterized in that** the at least one recess (82) forms a free hollow space variable in size.

## Revendications

1. Passe-câble (30) pour un boîtier de connexion ou d'appareil (10), comprenant une tubulure de boîtier (32) pouvant être immobilisée sur un tronçon de paroi (14) du boîtier de connexion ou d'appareil (10) et qui présente un corps de manchon (34) cylindrique par rapport à un axe médian (36) et s'étendant dans le sens d'un axe médian (36), un logement d'étanchéité (64) prévu dans la tubulure de boîtier (32), un élément d'étanchéité (60) disposé dans le logement d'étanchéité (64) pourvu d'un corps d'étanchéité (72) déformable et d'un canal de passage (74) traversant le corps d'étanchéité (72) en direction de l'axe médian (36) et présentant, dans un premier état de déformation du corps d'étanchéité (72), une section de passage plus grande que dans un deuxième état de déformation, et comprenant, de plus, un élément de pression (90) présentant un corps de pression (92) destiné à faire passer le corps d'étanchéité (72) du premier état de déformation à un deuxième état de déformation, lequel élément de pression peut coulisser axialement contre la tubulure de boîtier (32), est immobilisé contre la tubulure de boîtier (32) dans sa position de pression maintenant le corps d'étanchéité (72) dans le deuxième état de déformation et qui est pourvu d'au moins un élément d'encliquetage (102) qui, de son côté, peut être placé, dans la position d'encliquetage, dans un évidement (116) et entre en prise, dans la position d'encliquetage, dans un évidement (116) dans la tubulure de boîtier (32), **caractérisé en ce que** l'élément d'encliquetage (102) peut être déplacé radialement grâce au fait qu'il est aménagé d'un seul tenant contre le corps de pression (92), mais seulement sur le côté où un plan incliné (108) se termine par une face extérieure (106) du corps de pression (92), est relié de façon élastique au corps de pression (92) mais dégagé sur tous les autres côtés au moyen d'une brèche (114) par rapport au corps de pression (92).

2. Passe-câble selon la revendication 1, **caractérisé en ce que** l'élément de pression (90) se trouve, dans sa position de pression avec un corps de pression (92) agissant sur l'élément de pression (60), dans la tubulure de boîtier (32).

3. Passe-câble selon la revendication 1 ou la revendication 2, **caractérisé en ce que** l'élément de pression (90) est disposé, dans sa position de pression, avec le corps de pression (92) dans un logement de corps de pression (94) de la tubulure de boîtier (32).

4. Passe-câble selon l'une quelconque des revendications précédentes, **caractérisé en ce que** l'élément de pression (90) traverse le logement de corps de pression (94) de façon mobile dans le sens axial.

5. Passe-câble selon l'une quelconque des revendications précédentes, **caractérisé en ce que** l'élément de pression (90) est pourvu de plusieurs éléments d'encliquetage (102).

6. Passe-câble selon l'une quelconque des revendications précédentes, **caractérisé en ce que** l'élément de pression (90"") peut être positionné sur la tubulure de boîtier (32"") dans une position de montage dans laquelle il laisse le corps d'étanchéité (72) dans le premier état de déformation, et **en ce que**, en particulier, l'élément de pression (90"") est immobilisé dans la position de montage au moyen d'au moins un élément d'encliquetage (102) contre la tubulure de boîtier (32"").

7. Passe-câble selon l'une quelconque des revendications précédentes, **caractérisé en ce que** le corps d'étanchéité (72) n'est pas sollicité axialement dans le premier état de déformation.

8. Passe-câble selon l'une quelconque des revendications précédentes, **caractérisé en ce que** le corps d'étanchéité (72) présente une forme, dans le premier état de déformation, qui correspond à sa forme de fabrication.

9. Passe-câble selon l'une quelconque des revendications précédentes, **caractérisé en ce que** le corps d'étanchéité (72) est sollicité dans le sens axial et le sens radial dans le deuxième état de déformation.

10. Passe-câble selon l'une quelconque des revendications 1 à 8, **caractérisé en ce que** le corps d'étanchéité (72) est sollicité exclusivement dans le sens axial dans le deuxième état de déformation.

11. Passe-câble selon l'une quelconque des revendications précédentes, **caractérisé en ce que** le corps d'étanchéité (72), dans le deuxième état de déformation, est sollicité sur les deux faces frontales (66, 68) se faisant face au sens d'un raccourcissement d'une distance des faces frontales (66, 68).

12. Passe-câble selon l'une quelconque des revendications précédentes, **caractérisé en ce que** le corps d'étanchéité (72), dans le deuxième état de déformation, présente un contour intérieur (76) d'un canal de passage (74) rétrécissant la section de passage par rapport à la section de passage dans le premier état de déformation.

13. Passe-câble selon la revendication 12, **caractérisé en ce que**, dans le deuxième état de déformation, le contour intérieur (76) s'incurve radialement vers l'intérieur en partant des orifices d'extrémité (67, 69) du canal de passage (74) en direction d'une zone centrale (84) et **en ce qu'**en particulier le contour intérieur (76) présente une forme de type torique dans le deuxième état de déformation.

14. Passe-câble selon la revendication 12, **caractérisé en ce que** le corps d'étanchéité (72""'), dans le deuxième état de déformation, présente un contour intérieur (78""') rétréci vers l'intérieur radialement à l'axe médian (36) dans la zone proche des orifices d'extrémité (67""', 69""') du canal de passage (74""').

15. Passe-câble selon l'une quelconque des revendications précédentes, **caractérisé en ce que** le corps d'étanchéité (72) présente au moins un évidement (82) sur son côté opposé au canal de passage (82).

16. Passe-câble selon la revendication 15, **caractérisé en ce qu'**au moins un évidement (82) forme un espace creux libre dont la taille est variable.
